# EUROPEAN PATENT APPLICATION

(11) **EP 4 672 602 A1**
(43) Date of publication of application: **31.12.2025**
(21) Application number: 24185221.9
(22) Date of filing: 28.06.2024
(51) Int. Cl.: H03K 4/02, H03D 11/00, H04B 1/24

(54) **ELECTRONIC CIRCUIT AND METHOD FOR GENERATING A RAMPED CURRENT SIGNAL**

(71) Applicant: The Swatch Group Research and Development Ltd, 2074 Marin (CH)
(72) Inventor: AREND, Jean-Luc, 2035 Corcelles (CH); CASAGRANDE, Arnaud, 2014 Bôle (CH)
(74) Representative: ICB SA

(57) **Abstract**

In one aspect, the present invention concerns an electronic circuit (10) configured to generate a ramped current signal for a receiver circuit (30), the electronic circuit (1) comprising:
- a first current cell (20) comprising a first current source (55), a trigger input (25) to activate the first current source (55) and a trigger output (26),
- a second current cell (21) comprising a second current source (55'), a trigger input (25) to activate the second current source (55') and a trigger output (26), wherein the trigger output (26) of the first current cell (20) is connected to the trigger input (25) of the second current cell (21), and
- a current supply (24) connected to an input of the receiver circuit (30) and selectively connectable with any of the first current source (55) and the second current source (55').

## Description

### Field of the invention

In one aspect, the present invention relates to the field of electronic circuits, and in particular to electronic circuits configured or operable to generate or to provide a ramped current signal, e.g., for a receiver circuit, such as a regenerative receiver.

### Background

For generating a ramped current or bias signal, which may be useful in the operation of a regenerative receiver, e.g., a regenerated or super-regenerative receiver, it is usually necessary to generate a voltage ramp and convert this ramp signal to a current via a voltage-to-current converter. However, such approaches are limited by the additional noise of the converter and the reduced linearity of the converter, particularly when the supply voltage is low. Moreover, and in applications with regenerative receivers, and in particular with so-called super-regenerative receivers, such a current ramp generation must be supplemented by a system for measuring the start-up time and converting the start-up time to the digital domain, e.g. by way of a time-to-digital converter.

It is hence desirable to provide a precise, perfectly reproducible ramped current signal with an arbitrary short timing in an integrated structure to overcome the shortcomings as described above. It is a particular aim to provide an electronic circuit that is smaller in size and can be manufactured at moderate or low costs.

### Summary of the invention

The above-mentioned object will be solved and suitably addressed by an electronic circuit, by a regenerative receiver and by a method of generating a ramped current signal in accordance to the features of the independent claims. Various embodiments of the invention are subject matter of the dependent claims.

In one aspect, the present invention relates to an electronic circuit configured to generate a ramped current signal for a receiver circuit, such as a regenerative receiver, e.g. implemented as a so-called super-regenerative receiver. The electronic circuit comprises a first current cell. The first current cell comprises a first current source, a trigger input to activate the first current source and a trigger output.

The electronic circuit further comprises a second current cell. The second current cell comprises a second current source, a trigger input to activate the second current source and a trigger output. The trigger output of the first current cell is connected to the trigger input of the second current cell. The electronic circuit further comprises a current supply connected to a supply input of the receiver circuit.

The current supply is connectable or is connected with any of the first current source and the second current source. Specifically, the current supply may be connected in parallel to all available current cells. In this way, a first current provided by the first current source of the first current cell and a second current provided by the second current source of the second current cell may be both provided to the current supply. A total current provided by the current supply to the receiver circuit may comprise the sum of the first current from the first current source and the second current from the second current source.

The electronic circuit may comprise a cascade or chains of individual current cells. Insofar, the first current cell and the second current cell may be completed by further current cells, e.g. a third current cell, a fourth current cell and so on. The total number of current cells may be as large and 8 current cells, 16 current cells, 32 current cells, 54 current cells, 128 current cells, 256 current cells, 512 current cells, 1024 current cells and so on.

Typically and by providing a first signal to the trigger input of the first current cell, the first current cell may be activated or may be switched on such that a current provided by the first current source and to the current supply always connected or provided to the current supply towards the receiver circuit. Thereafter the trigger signal may be passed through the first current cell and may be present at the trigger output. Since the trigger output of the first current cell is connected to the trigger input of the second current cell, also the second current cell may be activated in the cascade of first and second current cells.

Accordingly, and when receiving a signal at the trigger input of the second current cell, the second current source may be activated thus adding a respective current to the current supply. Consequently, the total current provided at the current supply is increased by the second current. The cascade of subsequently activating numerous current sources of numerous current cells may be continued until the total current provided at the current supply reaches a final current or reference current.

In this way and since the activation of the second current cell via the trigger output of the first current cell is to be conducted at a certain time delay or transition time there will be provided a ramped current signal and an increasing current signal at the current supply over time.

With the electronic circuit as described herein there can be provided a current ramp by triggering a set of unitary current sources in a controlled manner and according to so-called thermometric progression. This enables a regular slope of the current ramp to be obtained at the current supply. The triggering system is provided by a chain or cascade of individual current cells whose transition time may be controlled by a control signal. Depending on the individual current sources of the current cells there can be provided a linear ramp signal but also any other progression of a current signal and the current supply.

According to a further example a supply current of the first current cell is identical to the supply current of the second current cell. Hence, a supply current provided by some or by each current cell may be equal to the supply current of any other current cell. In this way there can be provided a linear progression of the ramped current signal at the current supply provided that the transition time of the individual current cell, i.e., the time required for a trigger signal received at a trigger input and passed through the respective current cell to the respective trigger output may be substantially equal for all current cells.

According to a further example a supply current of the first current cell distinguishes from a supply current of the second current cell. By having individually designed current sources of first and second current cells that distinguish from each other there can be provided any required current ramp signal by selectively and sequentially activating the numerous current cells of the electronic circuit.

According to another example each one of the first current cell and the second current cell comprises a buffer to transfer an input signal at the trigger input to the trigger output of the respective current cell after lapse of a predefined transition time. In this way, the chain or cascade of individual current cells is not activated or switched on simultaneously but each cell is activated after the other and after lapse of a predefined transition time. The predefined transition time can be tunable in order to obtain a desired shape of the ramped current signal.

According to another example of the electronic circuit the current source of the respective current cell is connected to the current supply when a signal is provided at the trigger input of this particular current cell. Hence, when activated by a signal at the trigger input of any of the first or second current cells, the current source of the respective current cell is connected to the current supply. Once there has been provided a signal at the trigger input the current source of the respective current cell is activated and remains activated. Moreover and by providing a trigger signal at the trigger input of any of the first or second current cells the current source of the respective current cell is connected to the current supply and a current provided by the respective current cell adds to the total current provided by the current supply to the receiver circuit.

According to another example, each one of the first current cell and the second current cell comprises a logic unit. The logic unit comprises an interrupt input and an interrupt output. A signal at the interrupt output is indicative of an activation of the current source. It may comprise or represent a respective flag signal. In this way and by way of the logic unit an activation and/or an electrical connection between a current source of any of the first or second current cells to the current supply can be immediately indicated at the interrupt output.

In this way, there can be provided a digital signal at the interrupt output indicating activation and/or a contribution of a current source of a particular current cell to the total current available at the current supply. In this way and simply by counting a number of signals at interrupt outputs of activated current cells there can be derived a digital value representing the total current provided at the moment of interrupt of a startup time.

According to a further example each one of the first current cell and the second current cell comprises a logic unit. The logic unit comprises an interrupt input. In response to receive an interrupt signal at the interrupt inputs the logic unit is operable to decouple the current source from the trigger input. Insofar, the trigger chain of a number of current cells can be interrupted. Even though a trigger signal may propagate further from one current cell to the other for providing a signal to the trigger input of selected current cells, the respective current cell can be decoupled or disconnected from the trigger input. A trigger signal at a respective trigger input may then have no longer the effect of activating the current source.

In some examples all current cells of the electronic circuit are provided with a logic unit as described above and comprise an interrupt input. In some examples all interrupt inputs of all current cells may be activated, e.g. by receiving a respective interrupt signal. It may be then that the electronic circuit may be "frozen" and may provide a constant current at the current supply. Since the cascade or chain of the trigger inputs and trigger outputs of the individual current cells may be disconnected from the individual current sources, the trigger sequence may continue and may no longer have an effect on the generation of an output current at the current supply.

According to another example the logic unit is coupled to the trigger input and the logic unit is operable to provide a flag signal at the interrupt output in response to an input signal at the trigger input. In this way and by counting a number of flag signals at interrupt outputs it can be directly derived a number of current cells that have been activated to reach or to obtain a ramped current signal of predefined amplitude, strength or magnitude.

According to another aspect, the present disclosure also relates to a regenerative receiver. The regenerative receiver comprises a receiver circuit comprising a supply input. The regenerative receiver also comprises an electronic circuit as described above. Here, the current supply of the electronic circuit as described above is connected to the supply input of the receiver circuit. Since the regenerative receiver comprises an electronic circuit as described above, all features, effects and benefits as described above in connection with the electronic circuit equally apply to the regenerative receiver.

According to another example, the regenerative receiver further comprises an oscillation detector connected to a feedback line. The oscillation detector is further configured or operable to generate and to transfer a feedback signal to the feedback line when the current at the supply input equals or exceeds the current needed for oscillation of the regenerative receiver.

The feedback signal provided to the electronic circuit via the feedback line may be operable to freeze operation of the electronic circuit and to stop an ongoing increase of a current signal at the current supply.

According to a further example, the regenerative receiver comprises an electronic circuit provided with a logic unit as described above. The feedback line is connected to the interrupt inputs of the first current cell and the second current cell of the electronic circuit. In further examples the feedback line may be connected to all interrupt inputs of all current cells of the electronic circuit. In this way and when providing an interrupt signal via the feedback line the trigger input of all or of selected current cells can be decoupled from the respective current sources of the respective current cells. In this way, the electronic circuit can be frozen and the current as provided by the current supplier may have and maintain a constant level.

In some examples, the individual current cells of the electronic circuit and specifically the logic unit of the respective current cells may be provided with an enabling input. The logic unit may be operable to switch off the current source and/or to disconnect the current source from the current supply in response to receive a reset signal via the enabling input. The enable input of the logic unit may be provided with an enabling signal by way of which the logic unit may operate and may be operable to activate the current source and/or to connect the current source to the current supply in response to receive a trigger signal from the trigger input of that particular current cell.

According to another aspect the present invention also relates to a method of generating a ramped current signal for a receiver circuit. The method comprises the steps of activating a first current source of a first current cell of an electronic circuit as described above. The first current source is activated via a trigger input of the first current cell. Thereafter a second current source of a second current cell is activated via a trigger input of the second current cell, which trigger input of the second current cell is connected to a trigger output of the first current cell. The current supply for the receiver circuit as described above in connection with the electronic circuit is also connected to the first current source and to the second current source.

In the present context "activating of a current source" may be identical to connect an already activated current source to the current supply. Hence, the process of activating a current source may be conducted by simply connecting a current source with the current supply in order to provide a respective supply current to the receiver circuit. The method of generating a ramped current signal as described herein is particularly to be executed or conducted with an electronic circuit and/or with a regenerative receiver as described above. Insofar, all effects, features and benefits as described above in connection with the electronic circuit and/or with the regenerative receiver equally apply to the methods of generating the ramped current signal; and vice versa.

According to a further example, the second current source of the second current cell is activated by a trigger signal transferred from the trigger output of the first current cell to the trigger input of the second current cell. Insofar, the individual current cells and the respective current sources are successively activated by the chain or cascade of individual current cells. Accordingly, a first current cell is activated by a first trigger signal and the trigger input of the first current cell.

After lapse of a transition time or delay the respective trigger signal is transferred through to the trigger output of the first current cell and hence to the trigger input of the second current cell. In response to receive the trigger signal at trigger input of the second current cell, the second current sources is activated and adds a respective current to the current supply. This cascade or chain of activation of numerous current cells propagates and continues until the logic unit receives an interrupt signal via its interrupt input.

According to another example an input signal at the trigger input of any one of the first and second current cells is transferred to the trigger output of the respective first or second current cells after lapse of a predefined transition time. The transition time may be tunable and may define the total time required for the ramped current signal to reach a reference amplitude of predefined size.

According to another example the method further comprises deriving or determining a ramp time interval in the digital domain by counting a number of activated current cells or activated current sources. Counting of a number of activated current cells may be provided or supported by the logic units of the individual electronic circuits. Here, the interrupt output of each logic unit of each current cell may be directly indicative of an activation of the current source of this particular cell. By counting the number of activated current cells, e.g. by counting the flag signals at the individual interrupt outputs of the logic units of the individual current cells there can be provided a digital number that represents the number of activated current cells and/or activated current sources.

With a knowledge of the transition time and by multiplying the transition time with the number of activated current cells a total time interval required for reaching an amplitude needed in the ramped current signal can be provided rather easily and directly in the digital domain.

### Brief description of the drawings

In the following numerous examples of the invention will be described in greater detail by making reference to the drawings, in which:
- Fig. 1 shows a block diagram of an example of the regenerative receiver and
- Fig. 2 shows an example of a current cell of the electronic circuit of the receiver.

### Detailed description of the invention

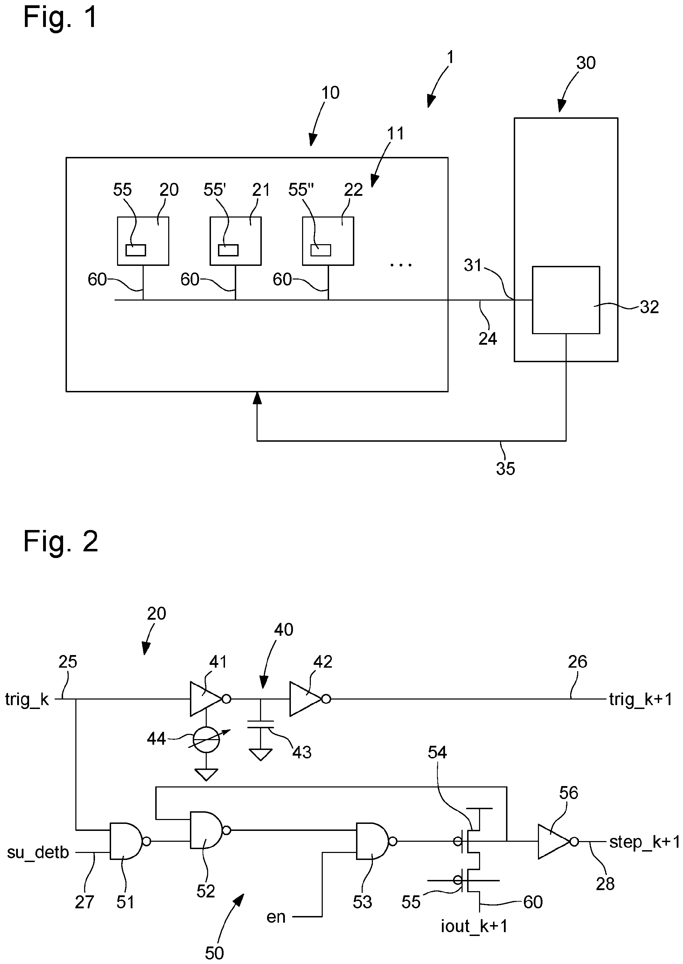

In Fig.1, there is shown a regenerative receiver 1. The regenerative receiver 1 comprises a receiver circuit 30, e.g., in form of a super-regenerative receiver. The regenerative receiver 1 comprises a receiver circuit 30 and an electronic circuit 10. The electronic circuit 10 is configured to supply a ramped current signal or ramped current to the receiver circuit 30 in order to start-up operation of the receiver circuit 30. The receiver circuit 30 inter alia comprises an oscillation detector 32. The supply input 31 is connected with a current supply 24 of the electronic circuit 10. The oscillator detector 32 may comprise an analog circuit which is operable to detect the oscillation of the regenerative receiver 30.

If the current at the supply input 31 should be equal to or larger than the current needed for oscillation of the regenerative receiver, the oscillation detector 32 is configured to generate and to provide a feedback signal via a feedback line 35 to the electronic circuit 10. When receiving such a feedback signal via the feedback line 35 the electronic circuit 10 may freeze and may stop generation or evolution of an increasing current at the current supply 24.

The electronic circuit 10 comprises numerous current cells 20, 21, 22. Each current cell 20, 21, 22 comprises a similar or identical structure, which is illustrated in Fig. 2. Each current cell 20, 21, 22 comprises a current source 55, 55', 55". Moreover, each current cell 20, 21, 22 is connected to the current supply 24 via a current output 60. The individual current cells 20, 21, 22 are arranged and connected in parallel with regards to the current supply 24. In this way, each current cell 20, 21, 22 may provide a current cell specific current, which add to a main current at the current supply 24.

As shown in Fig. 2 each current cell 20 (21,22) comprises a current source 55, a trigger input 25 and a trigger output 26. The individual cells 20, 21, 22 of the electronic circuit 10 are arranged to form a cascade arrangement 11 or chain of the current cells 20, 21, 22. The chain is formed by connecting the trigger output 26 of the first current cell 20 to the trigger input 25 of the second current cell 21.

A respective trigger output 26 of the second current cell 21 is connected to a trigger input 25 of the third current cell 22, and so on. In the illustration of Fig. 1 there are shown only three current cells 20, 21, 22 for reasons of simplicity. The number of individual current cells 20, 21, 22 can be arbitrarily expanded to a number of more than 20, more than 50, more than 100, more than 200, more than 500 or more than 1,000.

The trigger input 25 is connected to the trigger output 26 via a buffer 40. The buffer 40 comprises a first inverter 41 in series with a second inverter 42. The first inverter 41 is further connected with a buffer current source 44. The output of the first inverter 41 and the input of the second inverter 42 are mutually connected. The output of the second inverter 42 is connected to the trigger output 26.

A node located between the output of the first inverter 41 and the input of the second inverter 42 is connected with a buffer capacitor 43, which is connected to ground with an opposite end.

A trigger signal trig_k present at the trigger input 25 can propagate through the buffer 40 with a predefined delay. The rising flank of the trigger signal trig_k leads to the generation of a logical 0 at the output of the first inverter 41 by way of which the buffer capacitor 43 may discharge via the buffer current source 44. By way of this discharging process the voltage at the input of the second inverter 42 decreases at a particular rate and when a switching voltage for the second inverter 42 has been reached the output of the second inverter 42 changes its state from low to high.

Accordingly, there will be generated a trigger signal trig_k+1 at the trigger output 26 after lapse of a predefined transition time of the buffer 40. The transition time defines a kind of a discrete time interval at which the individual current(s) produced and provided by the individual current cells 20, 21, 22 can sum up to the total current provided at the current supply 24. The duration of the transition time may be controlled by tuning the buffer current source 44.

The individual current cells 20, 21, 22 each comprise a logic unit 50. The logic unit 50 operates on a rising edge of the trigger signal trig_k. Hence, the trigger input 25 can be processed by the logic unit 50 in such a way to switch on and/or to connect the first current source 55 to the current output 60, the latter of which being connected to the current supply 24 and provides an output current iout_k+1.

As particularly illustrated in Fig. 2 the current source 55 may be programmable and may provide a current of a predefined amplitude or size. In the embodiment as shown in Fig. 2 the current source 55 comprises a PMOS transistor that is in series with another PMOS transistor 54. The further PMOS transistor 54 acts as a switch for switching the current source 55 and hence for activating the current source 55 to deliver a current to the current output 60.

The logic unit 50 comprises a first gate 51, a second gate 52 and a third gate 53. The logic unit 50 further comprises an inverter 56. Moreover, the logic unit 50 comprises an interrupt input 27 and a current cell activation indicator output 28. The interrupt input 27 of each of the current cells 20, 21, 22 can be connected to the feedback line 35. The feedback line 35 may provide a su_detb signal to the interrupt input 27. The gates 51, 52 and 53 are all implemented as NAND gates. This has the benefit to implement such a logic structures with a comparatively low number of transistors. It is hence particularly suitable for miniaturization.

As illustrated in Fig. 2, the trigger input 25 is connected to a first input of the first gate 51 and the interrupt input 27 is connected to a second input of the gate 51. An output of the gate 51 is connected to an input of the second gate 52. The other input of the second gate 52 is connected to the gate of the switching transistor 54. The output of the second gate 52 is connected to an input of the third gate 53. Another input of the third gate 53 is connected to an enabling input en, which may be controllable by the receiver circuit 30. The output of the third gate 53 is connected to the gate of the switching transistor 54. An input of the inverter 56 is also connected to the gate of the switching transistor 54 and the output of the inverter 56 is connected to or forms the current cell activation indicator output 28 at which a step_k+1 signal and hence the number of current cells that are enables can be detected.

In an initial configuration and, when the electronic circuit 10 is in an idle mode before start-up, the trigger input 25 will not yet be provided with a trigger signal trig_k. The su_detb signal is initially at a logical 1. Accordingly, and in the initial state of the current cell 20 the output of the first gate 51 is a logical 1. The gate of the switching transistor 54 is at a logical 1 as well such that the output of the second gate 52 is at a logical 0. Since the electronic circuit 10 is in a working mode the enable signal en is at logical 1.

Accordingly, the output of the third gate 53 is at a logical 1 as well. Since the current cell activation indicator output 28 is connected to the gate of the switching transistor 54 via the inverter 56 there will be no signal present at the current cell activation indicator output 28.

When the electronic circuit 10 is now activated to generate a ramped current signal there will be provided a trigger signal trig_k at the trigger input 25. Toggling of the trigger input 25 from logical 0 to logical 1 will lead to the generation of a logical 0 at the output of the first gate 51. This logical 0 then leads to the generation of a logical 1 at the output of the second gate 52 and will induce the generation of a logical 0 at the output of the third gate 53. Turning down the gate of the PMOS switch 54 from logical 1 to logical 0 will activate the switch 54 such that the current source 55 will be activated and will provide a current source specific current to the current output 60. Furthermore, the logical 0 at the gate of the switching transistor 54 will be transferred into a logical 1 via the inverter 56 at the current cell activation indicator output 28.

Hence, at the current cell activation indicator output 28 there will arise a flag signal step_k+1 indicating that the current source 55 has been switched on or has been activated.

As already indicated above providing the trigger signal trig_k to the trigger input 25 will generate a respective trigger signal trig_k+1 at the trigger output 26, wherein the trigger signal trig_k+1 at the output will arise or will be generated after lapse of a predefined transition time interval. Thereafter, a proceeding current source 21 will undergo the same transition and will add a respective supplemental current to the current supply 24.

The cascade of numerous current cells 20, 21, 22 will continue and each current cell 20, 21, 22 will add current cell specific current to the current supply 24 until the oscillation detector 32 detects the oscillation of the regenerative receiver at the moment when the total current as provided by the current supply 24 reaches or exceeds the current needed for oscillation. When reaching such a current the oscillation detector 32 generates a feedback signal and transfers this feedback signal as a logical 0 via the feedback line 35 to all interrupt inputs 27 of all current cells 20, 21, 22.

With the trigger signal 25 at a logical 1 and with a switching of the su_detb signal from a logical 1 to a logical 0 the trigger input 25 will be effectively decoupled from the logic unit 50 and hence from the current source 55. Insofar and by setting the interrupt inputs 27 of the current cells 20, 21, 22 to a logical 0 there can be provided an effective decoupling of the trigger input 25 from the current source 55. Then, the output of the first gate 51 will always be at a logical 1 irrespective of the value or signal provided at the trigger input 25.

Insofar, setting the su_detb signal at each interrupt input 27 of the current cell 20, 21, 22 to a logical 0 effectively freezes the current switching state of all current cells 20, 21, 22 even though the trigger signal may further propagate through the number of individual current cells 20, 21, 22. It may have no longer an effect on the switching behavior of a respective switching transistor 54.

At the same time and with the freezing of each current cell 20, 21, 22 there can be provided a stable and continuous current at the current supply 24. At the same time the current cell activation indicator output 28 of all current cells 20, 21, 22 is immediately indicative of the activation of the respective current source 55 of each activated current cell 20, 21, 22. This way, there is immediately provided a digital signal being indicative of a number of current cells 20, 21, 22 that have been activated until the ramped current signal exceeds the current needed for oscillation of the regenerative receiver.

With a given transition time of each buffer 40 of the individual current cells 20, 21, 22 there can be derived a total ramp time in the digital domain that is required by the electronic circuit 10 to start oscillation of the regenerative receiver.

The ramped current signal at the current supply 24 can be resetted by supplying a reset signal to the enabling input en. Then, and in response to such a reset signal the gate of the switching transistor 54 may be set to a logical 1 thus switching the switching transistor off.

It should be noted that the presently illustrated implementation of the basis of NAND gates and on the basis of PMOS transistors 54, 55 is only illustrative. The same or similar implementation can be easily obtained also on the basis of a positive logic and on the basis of NMOS switching devices.

Especially in the case of implementing a so-called super-regenerative receiver, the generation of a current ramp by the present regenerative receiver 1 is of particular benefit as it becomes possible to obtain a start-up time directly in the digital domain by stopping the progression of the trigger chain, i.e., when the super-regenerative oscillator starts up, and consulting the thermometric number of current sources 55, 55', 55" that have been switched on, e.g., at the time the aforementioned oscillator starts up.

A simple thermometric to binary conversion can then be used to deduce the equivalent start-up time. The present type of thermometric generator is particularly well-suited to operation at very low voltages and has an ideal characteristic for "shrink" to smaller technologies. In the case of current generation, because the number of analog components is extremely limited, the noise performance of the system is excellent.

### Nomenclature

- 1: regenerative receiver
- 10: electronic circuit
- 11: cascade arrangement
- 20: current cell
- 21: current cell
- 22: current cell
- 24: current supply
- 25: trigger input
- 26: trigger output
- 27: interrupt input
- 28: current cell activation indicator output
- 30: receiver circuit
- 31: supply input
- 32: oscillation detector
- 35: feedback line
- 40: buffer
- 41: inverter
- 42: inverter
- 43: buffer capacitor
- 44: buffer current source
- 50: logic unit
- 51: gate
- 52: gate
- 53: gate
- 54: transistor
- 55: current source
- 56: inverter
- 60: current output

## Claims

1. An electronic circuit (10) configured to generate a ramped current signal for a receiver circuit (30), the electronic circuit (1) comprising:
- a first current cell (20) comprising a first current source (55), a trigger input (25) to activate the first current source (55) and a trigger output (26),
- a second current cell (21) comprising a second current source (55'), a trigger input (25) to activate the second current source (55') and a trigger output (26), wherein the trigger output (26) of the first current cell (20) is connected to the trigger input (25) of the second current cell (21), and
- a current supply (24) connected to a supply input (31) of the receiver circuit (30) and connectable with any of the first current source (55) and the second current source (55').

2. The electronic circuit (10) according to claim 1, wherein a supply current of the first current cell (55) distinguishes from a supply current of the second current cell (55').

3. The electronic circuit (10) according to any one of the preceding claims, wherein each one of the first current cell (20) and the second current cell (21) comprises a buffer (40) to transfer an input signal at the trigger input (25) to the trigger output (26) of the respective current cell (20, 21) after lapse of a predefined transition time.

4. The electronic circuit (10) according to any one of the preceding claims, wherein when activated by a signal at the trigger input (25) of any of the first or second current cells (20, 21) the current source (55, 55') of the respective current cell (20, 21) is connected to the current supply (24).

5. The electronic circuit (10) according to any one of the preceding claims, wherein each one of the first current cell (20) and the second current cell (21) comprises a logic unit (50), the logic unit (50) comprising an interrupt input (27) which is operable to decouple the current source (55, 55') from the trigger input (25) in response to receive an interrupt signal at the interrupt input (27).

6. The electronic circuit (10) according to claim 5, wherein the logic unit (50) further comprises and a current cell indicator output (28), wherein a signal at the current cell indicator output (28) is indicative of an activation of the current source (55).

7. The electronic circuit (10) according to claim 5 or 6, wherein the logic unit (50) is coupled to the trigger input (25) and wherein the logic unit (50) is operable to provide an indication signal at the current cell indicator output (28) in response to an input signal at the trigger input (25).

8. A regenerative receiver (1) comprising:
- a receiver circuit (30) comprising a supply input (31), and
- and an electronic circuit (10) according to any one of the preceding claims, wherein the current supply (24) of the electronic circuit (10) is connected to the supply input (31).

9. The regenerative receiver (1) according to claim 8, further comprising an oscillation detector (32) connected to a feedback line (35), wherein the oscillation detector (32) is configured to detect the oscillation of the regenerative receiver and is further configured to generate and to transfer a feedback signal to the feedback line (35) when the current at the supply input (31) equals or exceeds the current needed for oscillation.

10. The regenerative receiver (1) according to claim 9 and comprising an electronic circuit (10) according to any one of the claims 5-7, wherein the feedback line (35) is connected to the interrupt inputs (27) of the first current cell (20) and the second current cell (21) of the electronic circuit (10).

11. A method of generating a ramped current signal for a receiver circuit (30) the method comprising the steps of:
- activating a first current source (55) of a first current cell (20) of an electronic circuit (10) according to any one of the preceding claims 1-7 via a trigger input (25) of the first current cell (20),
- activating a second current source (55') of a second current cell (21) of the electronic circuit (10) via a trigger input (25) of the second current cell (21) which is connected to a trigger output (26) of the first current cell (20), and
- connecting a current supply (24) for the receiver circuit (30) to the first current source (55) and to the second current source (55)'.

12. The method according to claim 11, wherein the second current source (55') of the second current cell (21) is activated by a trigger signal transferred from the trigger output (26) of the first current cell (20) to the trigger input (25) of the second current cell (21).

13. The method according to claim 11 or 12, wherein an input signal at the trigger input (25) of any one of the first and second current cells (20, 21) is transferred to the trigger output (26) of the respective first or second current cell (20, 21) after lapse of a predefined transition time.

14. The method according to any one of the preceding claims 11-13, further comprising the steps of:
- detecting the current at the current supply (24) needed to start oscillation of the regenerative receiver and
- decoupling at least one of the first and second current sources (55, 55') from the trigger input (25) when the current at the current supply (24) is equal to or larger than the current needed to start oscillation of the regenerative receiver.

15. The method according to any one of the preceding claims 13 or 14 further comprising deriving or determining a ramp time interval in the digital domain by counting a number of activated current cells (20, 21) or activated current sources (55, 55').
